# EUROPÄISCHE PATENTSCHRIFT

(11) **EP 1 160 669 B1**
(45) Veröffentlichungstag und Bekanntmachung des Hinweises auf die Patenterteilung: **14.04.2004**
(21) Anmeldenummer: 01110795.0
(22) Anmeldetag: 04.05.2001
(51) Int. Cl.: G06F 11/20

(54) **Integrierter Halbleiterspeicher mit redundanter Einheit von Speicherzellen**
Integrated semiconductor memory with redundant cells
Mémoire de semiconducteur intégrée avec unité redondante de cellules mémoire

(30) Priorität: 29.05.2000 DE 10026654
(43) Veröffentlichungstag der Anmeldung: 05.12.2001
(73) Patentinhaber: Infineon Technologies AG, 81669 München (DE)
(72) Erfinder: Fischer, Helmut, Dr., 82024 Taufkirchen (DE); Krause, Gunnar, 81541 München (DE)
(74) Vertreter: Patentanwaltskanzlei WILHELM & BECK

(56) Entgegenhaltungen:
- WO-A-97/28532
- DE-A- 19 933 894
- US-A- 5 488 583
- US-B1- 6 292 383
- PATENT ABSTRACTS OF JAPAN vol. 1998, no. 08, 30. Juni 1998 (1998-06-30) & JP 10 064296 A (TEXAS INSTR JAPAN LTD), 6. März 1998 (1998-03-06)

## Beschreibung

Die Erfindung betrifft eine digitale Speicherschaltung, die ein oder mehrerer Felder von Speicherzellen in matrixförmiger Anordnung enthält. Hauptsächliches, jedoch nicht ausschließliches Anwendungsgebiet der Erfindung sind digitale Halbleiterspeicher wie z.B. DRAM-Speicher, in denen die Speicherzellen durch elektrische Kapazitäten gebildet sind, deren Ladezustand den Speicherinhalt repräsentiert.

Digitale Festkörperspeicher wie z.B. die genannten Halbleiterspeicher enthalten gewöhnlich eine oder mehrere matrixförmige Anordnungen aus X mal Y Speicherzellen. Um eine beliebige Speicherzelle einer solchen Matrix zum Einschreiben oder Lesen einer Information adressieren zu können, sind in der Matrix Zeilen und Spalten folgendermaßen definiert: Die Zeilen ("Rows") sind Y disjunkte Teilmengen von Speicherzellen, jeweils umfassend X Elemente, die an eine gemeinsame Zeilenleitung angeschlossen sind; die Spalten ("Columns") sind X disjunkte Teilmengen von Speicherzellen, jeweils umfassend Y Elemente, die an eine gemeinsame Spaltenleitung angeschlossen sind. Jede Speicherzelle ist somit eindeutig adressierbar durch Ansteuerung einer bestimmten Zeilenleitung und Auswahl einer bestimmten Spalte.

Zum Einschreiben oder Lesen einer Information an einer gewünschten Speicherzelle wird die Zeilenleitung, welche der die betreffende Zelle enthaltenden Zeile zugeordnet ist, durch Anlegen eines bestimmten Pegels seitens eines Zeilenadressendecoders aktiviert, wodurch alle Zellen dieser Zeile für einen möglichen Zugriff vorbereitet werden (Zeilenadressierung). Der eigentliche Zugriff erfolgt dann über dasjenige Exemplar der Spaltenleitungen, welches der die gewünschte Zelle enthaltenden Spalte zugeordnet ist. Zum Schreiben wird ein Pegel, der die einzuschreibende Information darstellt, an die betreffende Spaltenleitung gelegt; zum Lesen wird der Pegel, der in der gewünschten Zelle gespeichert ist und, aufgrund der aktivierten Zeilenleitung, von dieser Speicherzelle auf die betreffende Spaltenleitung gekoppelt wird, an dieser Spaltenleitung gefühlt. Gewöhnlich ist für jede Spalte der Speichermatrix eine gesonderte Schreib/Lese-Schaltung vorgesehen, und diese Schaltungen sind selektiv durch einen Spaltenadressendecoder ansteuerbar, um eine jeweils gewünschte Spaltenleitung zum Anlegen bzw. Fühlen des Informationspegels auszuwählen (Spaltenadressierung).

In den meisten Fällen sind die Speicherzellen binär, d.h. sie sind zur Speicherung jeweils eines Bits ausgelegt. Da die Spaltenleitungen diejenigen sind, welche die Speicherbits zu und von den Zellen übertragen, werden sie auch "Bitleitungen" genannt, während man die Zeilenleitungen gemeinhin auch als "Wortleitungen" bezeichnet.

Das räumliche Layout der Zeilen und Spalten und der Schreib/-Lese-Schaltungen einer Speichermatrix kann von Fall zu Fall unterschiedlich sein. Üblicherweise sind die Schreib/Lese-Schaltungen nebeneinander als eine oder mehrere Reihen angeordnet, die quer zur Spaltenrichtung verlaufen. Sie können entweder einen einzigen oder zwei Blöcke bilden, jeweils verlaufend außerhalb der Matrix entlang einem oder beiden zeilenparallelen Rändern des die Matrix bildenden Zellenfeldes. Der Block der Schreib/Lese-Schaltungen kann auch quer durch die Mitte der Matrix verlaufen, so daß jede Spalte von Speicherzellen und die zugeordnete Spaltenleitung aus zwei Abschnitten besteht, die sich von der betreffenden Schreib/-Lese-Schaltung in entgegengesetzte Richtungen erstrecken. In diesem Fall bildet die Matrix keinen lückenlos zusammenhängenden Aufbau mehr, sondern ist aufgeteilt in zwei Zellenfelder. Bei Speicherbänken großer Kapazität sind zumeist mehrere Blöcke von Schreib/Lese-Schaltungen vorgesehen, die sich, in Spaltenrichtung beabstandet, quer durch die Matrix erstrecken und jeweils für eigene Spaltenabschnitte zuständig sind. In diesem Fall ergeben sich in Spaltenrichtung mehr als zwei vielzeilige Segmente, deren jedes für sich ein zusammenhängendes Zellenfeld bildet.

Eine Speichermatrix kann nach ihrer Herstellung Defekte enthalten, entweder in den Speicherzellen selbst oder an den Zeilen- und Spaltenleitungen. Zur Bewältigung dieses Problems ist es üblich, die Matrix vor der weiteren Verwendung zu testen und diejenigen Zeilen und Spalten, in denen ein Defekt festgestellt wurde, durch eine defektfreie Zeile bzw. Spalte zu ersetzen. Um diese Reparaturmöglichkeit zu schaffen, wird die Matrix schon bei der Herstellung mit "redundanten" Zeilen und Spalten ausgestattet, zusätzlich zu den "regulären" Zeilen und Spalten, deren Anzahl die nominelle Speicherkapazität bestimmt.

Eine Reparatur, also das Ersetzen z.B. einer defektbehafteten regulären Zeile durch eine redundante Zeile, kann beispielsweise erfolgen, indem die Ausdecodierung der Zeilenleitung der defektbehafteten Zeile während des Betriebs unterdrückt wird und stattdessen die Zeilenleitung einer redundanten Zeile aktiviert wird. Das Ersetzen einer defektbehafteten Spalte kann nach ähnlichem Prinzip erfolgen. Diese Vorgänge werden üblicherweise mittels Laser an sogenannten Fuse-Bänken durchgeführt.

Bei digitalen Speicherschaltungen, insbesondere bei DRAM-Speichern, ist es üblich, die Spaltenleitungen zweiadrig als sogenannte "Bitleitungs-Pärchen" auszubilden. Hierbei ist es bekannt, das Layout so zu gestalten, daß sich die Adern zumindest einer Teilmenge der Spaltenleitungen an gewissen Orten gegenseitig überkreuzen. Dieser sogenannte "Bitleitungs-Twist", wie er z.B. in der US-Patentschrift 5 461 589 offenbart ist, soll parasitäre Kopplungen zwischen benachbarten Spaltenleitungen reduzieren.

Es wurde nun gefunden, daß vorhandene Bitleitungs-Twists Probleme verursachen können hinsichtlich des Ersetzens defektbehafteter Zeilen durch redundante Zeilen. Ein jeder Twist bewirkt nämlich, daß die Datentopologie jenseits des betreffenden Twistbereiches anders ist als diesseits. Der Begriff "Datentopologie" bezeichnet das Muster, in welchem die beiden Adern der einzelnen Spaltenleitungen den Zeilenleitungen zugeordnet sind, wodurch auch die physikalische Polarität der in den Zellen abgespeicherten Daten bestimmt wird. Wenn eine redundante Zeile, die als Ersatz für eine defektbehaftete reguläre Zeile eingeschaltet wird, nicht die gleiche Datentopologie hat, kann es Probleme vor allem beim Test des Speichers geben. Die Aufgabe der Erfindung besteht darin, solche Probleme zu beseitigen.

Diese Aufgabe wird erfindungsgemäß durch die Merkmale des Patentanspruchs 1 gelöst. Vorteilhafte Ausgestaltungen der Erfindung sind in den Unteransprüchen gekennzeichnet.

Gegenstand der Erfindung ist demnach eine digitale Speicherschaltung mit mindestens einem Zellenfeld, das eine Vielzahl von Speicherzellen in matrixförmiger Anordnung von Zeilen und Spalten enthält. Zusätzlich zu regulären Zeilen und Spalten von Speicherzellen sind redundante Zeilen von Speicherzellen als Ersatz für defektbehaftete reguläre Zeilen vorgesehen. Bei zumindest bei einer Teilmenge der Spalten überkreuzen sich Adern von Spaltenleitungen, über die der Zugriff auf die Speicherzellen erfolgt, an Orten zwischen den zeilenparallelen Rändern des Zellenfeldes, so daß sich die Datentopologie an diesen Orten ändert. Die redundanten Zeilen von Speicherzellen bilden getrennte Teilmengen, die in Regionen unterschiedlicher Datentopologie des Zellenfeldes angeordnet sind, derart daß für jede Datentopologie eine Teilmenge der redundanten Zeilen mit entsprechender Datentopologie verfügbar ist.

Die Erfindung hat den Vorteil, daß bei defektbehafteten regulären Zeilen in allen Fällen eine topologisch richtige Reparatur möglich ist. Das heißt, geeignete Schaltungsmittel können dafür sorgen, daß defektbehaftete reguläre Zeilen jeweils durch eine redundante Zeile mit entsprechender Datentopologie ersetzt wird. Die redundanten Zeilen jeder Teilmenge können irgendwo innerhalb der Region der betreffenden Topologie angeordnet sein, es gibt jedoch besonders vorteilhafte Anordnungen, wie nachstehend erläutert.

Wenn die Orte aller vorhandenen Twists auf einen einzigen Bereich zwischen zwei benachbarten Zeilen begrenzt sind, z.B. auf einen zeilenparallelen Bereich in der Mitte des Zellenfeldes, dann gibt es nur zwei Bereiche unterschiedlicher Datentopologie. In diesem Fall sind, in bevorzugter Ausführungsform der Erfindung, die redundanten Zeilen als getrennte Blöcke an den beiden entgegengesetzten zeilenparallelen Rändern des Zellenfeldes angeordnet. Ein wichtiger und überraschender Vorteil dieses Merkmals besteht darin, daß sich die durchschnittliche Häufigkeit des Auftretens reparaturbedürftiger Defekte vermindert. Es wurde nämlich gefunden, daß Defekte mit höherer Wahrscheinlichkeit dort auftreten, wo Irregularitäten im ansonsten regelmäßigen Aufbau einer Speichermatrix vorhanden sind. Die Außenränder der Matrix wie auch die Ränder der einzelner Segmente stellen solche Irregularitäten dar, denn an diesen Orten endet der regelmäßige (quasi "homogene") Aufbau des Zellenfeldes oder ist merklich unterbrochen. Somit erweisen sich die Ränder der Zellenfelder aus technologischen Gründen als reparaturanfälliger als der Kernbereich. Wenn nun die redundanten Exemplare von Zeilenund/oder Spaltenleitungen auf zwei Blöcke an beiden entgegengesetzten Rändern des Zellenfeldes verteilt sind, sinkt die Anzahl randnaher regulärer Exemplare und somit die Wahrscheinlichkeit von Defekten an regulären Zeilen bzw. Spalten. Somit sinkt auch die Anzahl der Reparaturen. Eventuelle Defekte verteilen sich stattdessen mehr auf die redundanten Exemplare. Defektbehaftete redundante Zeilen bzw. Spalten können zwar nicht mehr zur Reparatur verwendet werden, sie erzeugen ihrerseits aber auch keinen Reparaturaufwand. Insgesamt wird also die Wirtschaftlichkeit erhöht. Eine ähnlicher Vorteil läßt sich auch erzielen, wenn man eine oder mehrere Exemplare der redundanten Zeilen der einen und/oder anderen Teilmenge direkt angrenzend am Twistbereich anordnet, denn auch hier gibt es eine gewisse Unterbrechung des quasi homogenen Aufbaus des Zellenfeldes, welche die Defektwahrscheinlichkeit erhöhen kann.

Wenn das Zellenfeld auch mehrere redundante Spalten von Speicherzellen enthält, können die redundanten Spalten ebenfalls zwei getrennte Blöcke bilden, die an den beiden entgegengesetzten spaltenparallelen Rändern des Zellenfeldes angeordnet liegen. Die Anordnung redundanter Zeilen oder Spalten an jeweils beiden gegenüberliegenden Rändern eines Zellenfeldes ist bisher nur für Zellenfelder ohne Bitleitungs-Twist vorgeschlagen worden (vgl. DE 199 33 894 A1).

Häufig ist es erwünscht, mehrere beabstandete Twistbereiche zwischen den zeilenparallelen Rändern vorzusehen, wobei die Spaltenleitungsadern, die sich in den verschiedenen Twistbereichen überkreuzen, nicht identisch sind. Hier reicht es nicht aus, redundante Zeilen nur an beiden Rändern des Zellenfeldes vorzusehen, denn in solchen Fällen gibt es mehr als zwei verschiedene Datentopologien und demnach auch mehr als zwei Regionen unterschiedlicher Datentopologie, von denen manche zwischen benachbarten Twistbereichen liegen. In solchen Regionen sind redundante Zeilenleitungen vorzugsweise direkt angrenzend an den einen und/oder anderen der benachbarten Twistbereiche angeordnet.

Die Erfindung wird nachstehend an zwei Ausführungsbeispielen anhand der beigefügten Zeichnungen näher erläutert.
- Fig. 1: zeigt schematisch einen Ausschnitt aus einem Zellenfeld mit einem einzigen Twistbereich.
- Fig. 2: zeigt schematisch einen Ausschnitt aus einem Zellenfeld mit drei Twistbereichen.

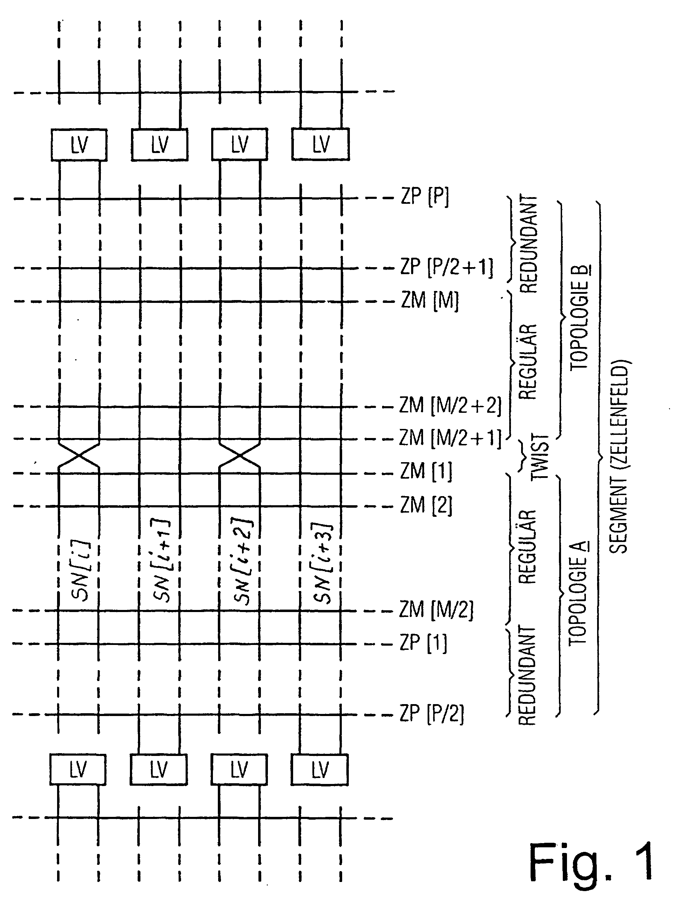

Das Zellenfeld nach Fig. 1 enthält eine große Vielzahl von Speicherzellen, die nach Art einer rechtwinkligen Matrix angeordnet sind. Aus Gründen der Übersichtlichkeit der Zeichnung sind die Speicherzellen selbst nicht dargestellt, gezeigt sind lediglich, als horizontale und vertikale Linien, die dem Zugriff auf die Zellen dienenden Zeilen- bzw. Spaltenleitungen. Die Speicherzellen sind zu denken als Elemente, die einzelnen Überkreuzungspunkten der Zeilen- und Spaltenleitungen zugeordnet sind. Jede Gruppe von Speicherzellen, die einer gemeinsamen Zeilenleitung zugeordnet sind, wird im folgenden als "Zeile" bezeichnet. In ähnlicher Weise wird jede Gruppe von Speicherzellen, die einer gemeinsamen Spaltenleitung zugeordnet sind, als "Spalte" bezeichnet. In der Zeichnung sind die Bezugszeichen für die Zeilen und Spalten jeweils an den betreffenden Zeilen- und Spaltenleitungen eingetragen.

Das in der Zeichnung fragmentarisch dargestellte Zellenfeld ist ein "Segment" einer Speicherbank und enthält eine Anzahl M regulärer Zeilen ZM[1] bis ZM[M] und einer Anzahl P redundanter Zeilen ZP[1] bis ZP[P]. Das Zellenfeld liegt zwischen zwei Blöcken von Leseverstärkern LV, die Bestandteile der Schreib/Lese-Schaltungen der Speicherbank bilden. Diese Blöcke erstrecken sich jeweils parallel zu den Zeilen und begrenzen somit das besagte Zellenfeld am "oberen" und "unteren" Rand. Wie in der Zeichnung angedeutet, können jenseits der Blöcke von Leseverstärkern LV weitere gleichartige Zellenfelder liegen, wenn die Speicherbank (wie in den meisten praktischen Fällen) aus mehreren Segmenten besteht. Bei einer typischen Ausführungsform kann ein Segment z.B. aus M = 1024 regulären Zeilen und P = 24 redundanten Zeilen bestehen.

Das betrachtete, aus M+P Zeilen bestehende Zellenfeld (und gegebenenfalls auch die anderen gleichartigen Zellenfelder) enthält N reguläre Spalten SN[1] bis SN[N]. Das Produkt von M und N bestimmt die nominelle Speicherkapazität des Zellenfeldes (in Bits, wenn es sich um binäre Speicherzellen handelt). Der dargestellte Ausschnitt zeigt das Zellenfeld nur über einen Teil seiner Breite, umfassend vier mittlere Exemplare SN[i] bis SN[i+3] der Spalten. Die Spaltenleitungen der einzelnen Spalten sind zweiadrig, und jedes Aderpaar (Bitleitungs-Pärchen) ist an jeweils einen zugeordneten Leseverstärker LV angeschlossen. Im dargestellten Fall ist jede zweite Bitleitung, also jedes zweite Aderpaar, mit alternierenden Exemplaren derjenigen Leseverstärker LV verbunden, die im Block längs des einen Randes des Zellenfeldes liegen. In ähnlicher Weise sind die dazwischen liegenden Spaltenleitungen mit alternierenden Exemplaren der Leseverstärker auf der anderen Seite des Zellenfeldes verbunden. Die übrigen Leseverstärker LV der beiden Blöcke sind den Zellenfeldern der benachbarten Segmente der Speicherbank zugeordnet. Diese Zuordnung zwischen Spaltenleitungen und Leseverstärker-Blöcken ist jedoch nicht zwingend, sie entspricht aber üblicher Praxis.

Beim Ausführungsbeispiel nach Fig. 1 ist das (oder jedes) Zellenfeld mit sogenanntem Bitleitungs-Twist versehen, derart, daß sich in der Mitte des Feldes, innerhalb eines sich quer zu den Spalten erstreckenden Bereiches zwischen zwei Zeilen, die Adern mancher Spaltenleitungen überkreuzen. Im Falle der Fig. 1 ist ein derartiger Twist in jeder zweiten Spalte vorhanden. Dies ist jedoch nur ein Beispiel, es sind auch andere Muster möglich. Jedes Twist-Muster führt dazu, daß auf der einen Seite des Twistbereiches die Zuordnung der Adern der Spaltenleitungen zu den Zeilenleitungen ein anderes Schema hat als auf der anderen Seite. Es ergeben sich somit durch den Twist zwei Regionen unterschiedlicher "Datentopologie" A und B.

Im Betrieb werden die Zeilenleitungen von einem Zeilenadressendecoder über zugeordnete Treiber selektiv angesteuert, und die zugeordneten Leseverstärker werden von einem Spaltenadressendecoder selektiv ausgewählt, zum Schreiben oder Lesen einer Information an derjenigen Speicherzelle, die der angesteuerten Zeilenleitung und der durch den ausgewählten Leseverstärker bestimmten Spalte zugeordnet ist. Die hierzu verwendeten Schaltungen sind allgemein bekannt und in der Zeichnung nicht eigens dargestellt, ebenso weggelassen sind auch die zugehörigen Anschlüsse an den Leseverstärkern.

Bei der in Fig. 1 dargestellten Ausführungsform bildet die eine Hälfte ZP[1] bis ZP[P/2] der P redundanten Zeilen einen ersten "Redundanzblock" am unteren Rand des Zellenfeldes, und die andere Hälfte ZP[P/2+1] bis ZP[P] bildet einen zweiten Redundanzblock am oberen Rand. Das heißt, die redundanten Zeilen sind an beiden zeilenparallelen Rändern des Zellenfeldes die randnächsten Elemente der Gesamtmenge von M+P Zeilen. Diese Aufteilung der redundanten Zeilen ZP[1] bis ZP[P] auf zwei getrennte Blöcke am oberen und unteren Rand des Zellenfeldes führt dazu, daß die jede Region der Datentopologie A oder B redundante Zeilen der gleichen Topologie enthält, so daß bei einem Defekt einer regulären Zeile der einen oder anderen Topologie in jedem Fall eine redundante Zeile gleichartiger Topologie als Ersatz zur Verfügung steht.

Ein weiterer Vorteil der Anordnung nach Fig. 1 ist die weiter oben erwähnte verminderte Defektanfälligkeit der regulären Zeilen ZM[1] bis ZM[M], da keine dieser Zeilen im Randbereich des Zellenfeldes liegt. Ein entsprechender Vorteil läßt sich auch in Bezug auf die Spalten erzielen, wenn das Zellenfeld mit redundanten Spalten als Ersatz für defektbehaftete reguläre Spalten ausgestattet ist und man die redundanten Spalten in zwei getrennte Blöcke an entgegengesetzten spaltenparallelen Rändern des Zellenfeldes aufteilt (in der Zeichnung nicht dargestellt), was die Defektanfälligkeit der regulären Spalten vermindert.

Die beiden Teilmengen redundanter Zeilen müssen aber nicht unbedingt an den beiden äußeren Rändern des Zellenfeldes angeordnet sein, sondern können im Grunde an beliebigen Stellen der jeweiligen Region der betreffenden Datentopologie liegen. Das heißt, wenn nur ein Twistbereich wie im Falle der Fig. 1 vorhanden ist, können die beiden Teilmengen redundanter Zeilen irgendwo beidseitig eines vorhandenen Twistbereiches liegen. Obwohl dies auf Kosten des weiter oben erwähnten Vorteils verminderter Defektanfälligkeit gehen mag, ist die Erfindung nicht auf die in der Fig. 1 dargestellte Randlage der redundanten Zeilen beschränkt.

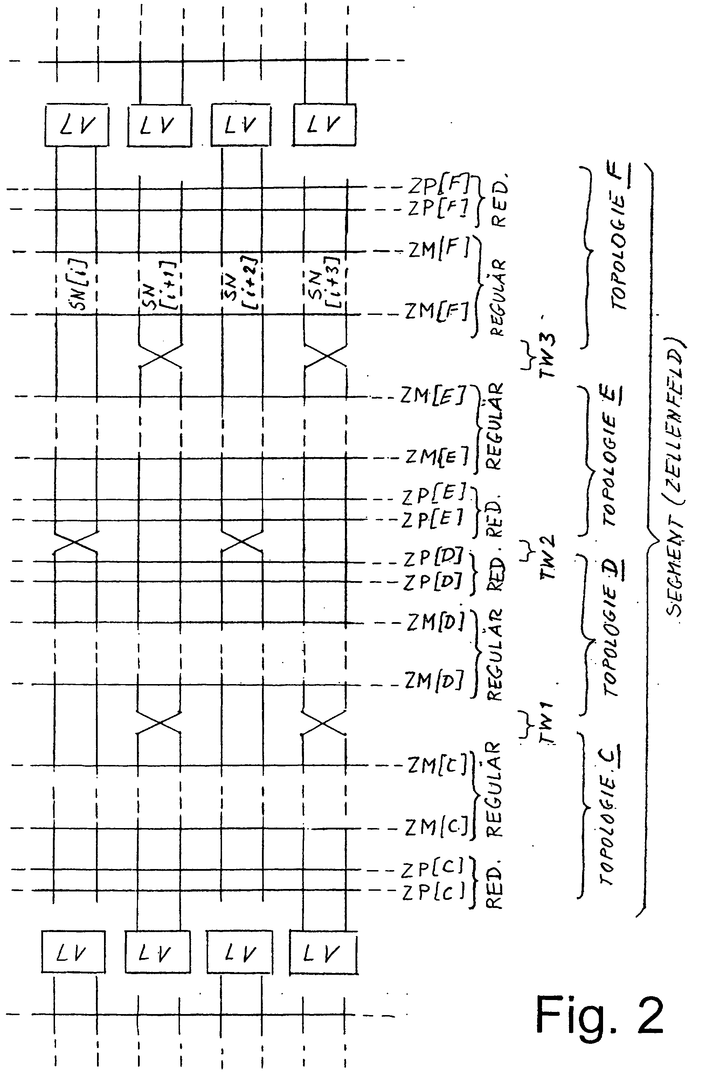

Die Fig. 2 zeigt ein Beispiel für die Aufteilung der redundanten Zeilen in einem Zellenfeld, das mehrere beabstandete Twistbereiche hat. Die gezeigte Anordnung unterscheidet sich von derjenigen nach Fig. 1 darin, daß die Spaltenleitungsadern nicht nur jeder zweiten Spalte SN[i], SN[i+2], usw. in einen Twistbereich TW2 der Mitte des Zellenfeldes getwistet sind, sondern daß auch die Spaltenleitungen der dazwischen liegenden Spalten SN[i+1], SN[i+3], usw. getwistet sind, und zwar jeweils zweimal. Es sind somit zwei weitere Twistbereiche TW1 und TW3 vorhanden, wobei TW1 mitten zwischen TW2 und dem "unteren" zeilenparallelen Rand des Zellenfeldes liegt und TW3 mitten zwischen TW2 und dem "oberen" zeilenparallelen Rand des Zellenfeldes liegt.

Das in Fig. 2 dargestellte Twistmuster führt dazu, daß es vier Regionen unterschiedlicher Datentopologie gibt. Die Region zwischen dem unteren Rand und dem Twistbereich TW1 hat die Topologie C. Die Twists im Bereich TW1 haben zur Folge, daß sich jenseits TW1 eine andere Topologie D ergibt. In ähnlicher Weise haben die Regionen zwischen TW2 und TW3 und zwischen TW3 und dem oberen Rand des Zellenfeldes besondere Topologien E bzw. F, die sich sowohl voneinander als auch von den Topologien C und D unterscheiden.

Entsprechend den vier verschiedenen Datentopologien C, D, E und F gliedert sich die Gesamtmenge der regulären Zeilen in vier Teilmengen, deren Topologie unterschiedlich ist und deren Elemente in Fig. 2 mit ZM[C], ZM[D], ZM[E] und ZM[F] bezeichnet sind. Um beliebige reguläre Zeilen ZM durch eine redundante Zeile ZP jeweils entsprechender Topologie ersetzen zu können, ist erfindungsgemäß die Gesamtmenge der redundanten Zeilen ZP ebenfalls in vier Teilmengen aufgeteilt, deren Elemente mit ZP[C], ZP[D], ZP[E] und ZP[F] bezeichnet sind. Jede dieser vier Teilmengen liegt in einer anderen der vier verschieden Topologie-Regionen.

In der Fig. 2 sind, zur Vereinfachung der Darstellung, in jeder Topologie-Region nur zwei redundante Zeilen eingezeichnet. Die redundanten Zeilen ZP[C] der Topologie C liegen vorzugsweise als Block direkt angrenzend an den unteren Rand des Zellenfeldes, und die redundanten Zeilen ZP[F] der Topologie C liegen vorzugsweise als Block direkt angrenzend an den oberen Rand des Zellenfeldes. Dies hat den oben erwähnten Vorteil, daß die regulären Zeilen größtmöglichen Abstand von den zeilenparallelen Rändern des Zellenfeldes haben und somit die Defektwahrscheinlichkeit für reguläre Zeilen minimiert ist. Die redundanten Zeilen ZP[E] der Topologie E und die redundanten Zeilen ZP[F] der Topologie F liegen vorzugsweise als Blöcke direkt angrenzend an jeweils einen Twistbereich, im dargestellten Fall beidseitig des Twistbereiches TW2. Dies vermindert die Anzahl twistnaher regulärer Zeilen, die unter Umständen anfälliger für Defekte sind als twistferne Zeilen.

Die Erfindung ist natürlich nicht beschränkt auf die in Fig. 2 gezeigte Lage der redundanten Zeilen ZP innerhalb der jeweiligen Topologie-Region. Im Grunde wird der Hauptzweck der Erfindung, nämlich die Möglichkeit topologisch richtiger Reparatur, mit jeder beliebigen Anordnung der redundanten Zeilen innerhalb der jeweiligen Topologie-Region erreicht. Die erwähnten zusätzlichen Vorteile verminderter Defektanfälligkeit regulärer Zeilen werden auch erzielt, wenn man innerhalb jeder Topologie-Region redundante Zeilen an beiden Rändern der betreffenden Region anordnet, also sowohl beidseitig jedes Twistbereiches als auch an jedem zeilenparallelen Rand des Zellenfeldes.

Ebensowenig ist die Erfindung beschränkt auf die in Figuren als Beispiel dargestellten Twistmuster, sie ist anwendbar auf Speicherzellen mit beliebigen Twistmustern und beliebig hoher Anzahl von Twistbereichen. Das gilt auch für Twists, bei denen die beiden Adern einer Spaltenleitung nicht untereinander verkreuzt werden, sondern Adern anderer Spaltenleitungen überkreuzen. Bei manchen Twistmustern kann es vorkommen, daß bestimmte Datentopologien nach einer gewissen Anzahl von Twistbereichen ein- oder mehrmals wiederkehren. In solchen Fällen ist die "Region" der betreffenden Topologie gleichsam in zwei oder mehr voneinander entfernte Abschnitte gegliedert. Die Elemente der dieser Topologie zugeordneten Teilmenge der redundanten Zeilen können dann entweder alle in einem dieser Abschnitte liegen oder auf die einzelnen Abschnitte verteilt sein.

## Patentansprüche

1. Digitale Speicherschaltung mit mindestens einem Zellenfeld, das eine Vielzahl von Speicherzellen in matrixförmiger Anordnung von Zeilen und Spalten enthält, wobei
- zusätzlich zu regulären Zeilen (ZM) und Spalten (SN), deren Anzahlen die nominelle Speicherkapazität des Zellenfeldes bestimmen, redundante Zeilen (ZP) von Speicherzellen als Ersatz für defektbehaftete reguläre Zeilen vorgesehen sind,
**dadurch gekennzeichnet daß**
- sich zumindest bei einer Teilmenge der Spalten Adern von Spaltenleitungen, über die der Zugriff auf die Speicherzellen erfolgt, an Orten zwischen den zeilenparallelen Rändern des Zellenfeldes überkreuzen, so daß sich die Datentopologie an diesen Orten ändert, und dadurch daß
- die redundanten Zeilen (ZP) von Speicherzellen getrennte Teilmengen bilden, die in Regionen unterschiedlicher Datentopologie des Zellenfeldes angeordnet sind, derart daß für jede Datentopologie eine Teilmenge der redundanten Zeilen mit entsprechender Datentopologie verfügbar ist, wobei der Begriff "Datentopologie" das Muster begeichnet, in welchem die beiden Adern den eingelnen Spaltenleitungen den Zeilenleitungen angeordnet sind, wodurch auch die physikalische Polarität der in den Zellen abgespeicherten Daten bestimmt wird.

2. Digitale Speicherschaltung nach Anspruch 1, worin die Elemente jeder Teilmenge (ZP[1]-ZP[P/2), ZP[P/2+1]-ZP[P]; ZP[C], ZP[F]) redundanter Zeilen, die in einer Region angeordnet ist, welche einem zeilenparallelen Rand des Zellenfeldes benachbart ist, zumindest teilweise direkt angrenzend an diesem Rand angeordnet sind.

3. Digitale Speicherschaltung nach Anspruch 1 oder 2, worin die Elemente jeder Teilmenge (ZP[D], ZP[E]) redundanter Zeilen, die sich in einer Region zwischen zwei benachbarten zeilenparallelen Bereichen (TM1, TM2, TW3) befindet, in denen sich Spaltenleitungsadern überkreuzen, zumindest teilweise direkt angrenzend an zumindest einem (TW2) dieser Bereiche angeordnet sind.

4. Digitale Speicherschaltung nach einem der vorhergehenden Ansprüche, wobei
- das Zellenfeld zusätzlich zu regulären Zeilen (ZM) und Spalten (SN) mehrere redundante Spalten von Speicherzellen als Ersatz für defektbehaftete reguläre Spalten enthält,
- und die redundanten Spalten von Speicherzellen als zwei getrennte Blöcke an den beiden entgegengesetzten spaltenparallelen Rändern des Zellenfeldes angeordnet sind.

## Claims

1. A digital memory circuit having at least one cell array which contains a multiplicity of memory cells in a matrix-like arrangement of rows and columns, where
- in addition to regular rows (ZM) and columns (SN) whose numbers determine the nominal storage capacity of the cell array, redundant rows (ZP) of memory cells are provided as replacement for faulty regular rows,
**characterized in that**
- at least for a subset of the columns, wires of column lines used to access the memory cells intersect one another at locations between the edges of the cell array which are parallel to the rows, so that the data topology changes at these locations, and **in that**
- said redundant rows (ZP) of memory cells form separate subsets which are arranged in regions of different data topology in the cell array, such that, for each data topology, a subset of the redundant rows is available with an appropriate data topology, whereby the term "data topology" denotes the pattern in which the two wires of the individual column lines are associated with the row lines, whereby the physical polarity of the data stored in the cells is defined as well.

2. The digital memory circuit as claimed in claim 1, in which at least some of the elements of each subset (ZP[1]-ZP[P/2], ZP[P/2+1]-ZP[P]; ZP[C], ZP[F]) of redundant rows which is arranged in a region adjacent to an edge of the cell array which is parallel to the rows are arranged directly adjacent to this edge.

3. The digital memory circuit as claimed in claim 1 or 2, in which at least some of the elements of each subset (ZP[D], ZP[E]) of redundant rows which is situated in a region between two adjacent areas (TW1, TW2, TW3), parallel to the rows, in which column line wires intersect one another are arranged directly adjacent to at least one (TW2) of these areas.

4. The digital memory circuit as claimed in one of the preceding claims, where
- in addition to regular rows (ZM) and columns (SN), the cell array contains a plurality of redundant columns of memory cells as replacement for faulty regular columns,
- and the redundant columns of memory cells are arranged as two separate blocks at the two opposite edges of the cell array which are parallel to the columns.

## Revendications

1. Circuit de mémoire numérique avec au moins un champ de cellules contenant une pluralité de cellules de mémoire disposées en une matrice de lignes et de colonnes, où, en plus de lignes (ZM) et de colonnes (SN) régulières, dont le nombre détermine la capacité de mémoire nominale du champ de cellules, des lignes redondantes (ZP) de cellules de mémoire sont prévues pour le remplacement de lignes régulières défectueuses, **caractérisé en ce qu'**au moins pour une partie des colonnes, des brins de conducteurs de colonnes, qui permettent l'accès aux cellules de mémoire, s'entrecroisent à des endroits situés entre les bords parallèles aux lignes du champ de mémoire, de telle sorte que la topologie des données se modifie à ces endroits, et **en ce que** les lignes redondantes (ZP) des cellules de mémoire constituent des quantités partielles séparées disposées dans des régions de topologie de données différentes du champ de cellule, de telle sorte que, pour chaque topologie de données, une partie des lignes redondantes soit disponible avec la topologie de données correspondante, où le terme « topologie des données » désigne la trame dans laquelle les deux brins des différents conducteurs de colonnes correspondent aux conducteurs de lignes, ce qui détermine également la polarité physique des données enregistrées dans les cellules.

2. Circuit de mémoire numérique selon la revendication 1, dans lequel les éléments de chaque partie (ZP[1]-ZP[P/2], ZP[P/2+1]-ZP[P] ; ZP[C], ZP[F]) des lignes redondantes qui est disposée dans une région voisine d'un bord parallèle aux lignes du champ de cellules, sont, au moins en partie, directement en contact avec ce bord.

3. Circuit de mémoire numérique selon la revendication 1 ou 2, dans lequel les éléments de chaque partie (ZP[D], ZP[E]) des lignes redondantes, qui se trouve dans une région entre deux zones (TW1, TW2, TW3) voisines parallèles aux lignes, dans lesquelles les brins des conducteurs de colonnes s'entrecroisent, sont, au moins en partie, directement en contact avec au moins une de ces zones (TW2).

4. Circuit de mémoire numérique selon l'une des revendications précédentes, moyennant quoi le champ de cellules comprend, en plus des lignes (ZM) et des colonnes (SN) régulières, plusieurs colonnes redondantes de cellules de mémoire pour le remplacement des colonnes régulières défectueuses, et les colonnes redondantes de cellules de mémoire sont disposées comme deux blocs séparés au niveau des deux bords opposés et parallèles aux colonnes du champ de cellules.
